# EUROPEAN PATENT APPLICATION

(11) **EP 1 184 481 A2**
(43) Date of publication of application: **06.03.2002**
(21) Application number: 01500202.5
(22) Date of filing: 27.07.2001
(51) Int. Cl.: C23C 14/08, C23C 14/35, C03C 17/245

(54) **Method for obtaining transparent, electrically conducting oxides by means of sputtering**

(30) Priority: 28.08.2000 ES 200002141
(71) Applicant: CENTRO DE INVESTIGACIONES ENERGETICAS MEDIOAMBIENTALES Y TECNOLOGICAS (C.I.E.M.A.T.), E-28040 Madrid (ES)
(72) Inventor: Martinez Calvo, Maria Angeles, 28017 Madrid (ES); Gutierrez Garcia, Maria Teresa, 28029 Madrid (ES); Herrero Rueda, Jose, 28027 Madrid (ES)
(74) Representative: Del Santo Abril, Natividad

(57) **Abstract**

The invention consists of depositing tin-doped indium oxide and aluminium-doped zinc oxide on glass substrates without intentional heating, by means of the sputtering technique. It consists of the following stages:
In order to prepare them, substrates are degreased and cleansed in an ultrasonic bath, rinsed in deionised water and dried with air jet.
The substrates to be coated are then placed in a sputtering chamber and bombarded with Ar+ ions.
Indium oxide or zinc oxide target surfaces are prepared by bombarding them with Ar+ ions.
The substrates are coated with the material which makes up the targets, whilst a flux of argon and oxygen is maintained in the sputtering chamber. The oxygen flux should preferably be between 0.5 and 1sccm. The radiofrequency power density throughout this procedure is between 4000 and 10000 mW/cm2.
This process allows us to obtain thin films of both materials with high electrical conductivity and high transparency to visible light.

## Description

The present invention refers to a preparation process of transparent electrodes on glass substrates in order to obtain high electrical transparency and conductivity without intentional heating of said substrates.

The presence of both high optical transparency in the visible region, more than 80%, together with high electrical conductivity, equal to or greater than 10³ ( cm)⁻¹, cannot be achieved with intrinsic esthequiometric material. The only possible way to obtain good transparent conductors is by using compounds with high charge carrier concentrations and an optical absorption boundary that starts at high energy levels. That is why cadmium, tin, indium, zinc and their alloys are a perfect combination of the required optical and electrical properties. These degenerated oxides are n-type semiconductors and their transmission generally depends on the spectrum region. For low wavelength zones they show high ultraviolet absorption, whereas for higher wavelengths than those of visible light they produce around 90% infra red reflectivity. Between the two zones there exists a region where they are transparent to the visible spectrum. These electronically conductive oxides are therefore optically selective. They are transparent to visible light and reflective to infra red light They usually adopt a non esthequiometric form which results in structures with defects or irregularities. These irregularities, caused by an absence (vacancies) or a presence (interstitial atoms) of atoms that make up the glass network, are known as "intrinsic doping". There is always the possibility of increasing carrier concentration by adding external impurities, introducing them into the oxide networks. Some notable examples of "extrinsic" doping are:
- Tin-doped indium oxide (ITO). In this compound the tin atoms are added to the In₂O₃ network as Sn⁴⁺ at In³⁺ positions and they provide a quasi-free electron that can participate in the conduction mechanism.
- Aluminium-doped zinc oxide. Al:ZnO. This group III element is added to the ZnO network as Al³⁺ at Zn²⁺ positions in order to provide a quasi-free electron.

Due to their properties described above, transparent conducting oxides (TCO's) are ideal materials for many applications including: gas sensors, thermal mirrors, reflection absorption tandems for photometric conversion, electrochromic devices, light-emitting diodes, liquid glass panels and photovoltaic solar cells.

It should be noted that both optical and electrical properties depend on the film microstructure, esthequiometrics and impurities, and that each technique with its associated parameters produces different properties. Some of the techniques used to prepare these compounds are: thermal evaporation, evaporation by means of an electron beam, aerosol pyrolysis, chemical vapour deposition and cathode grinding, Z.M. Jarzebski in "Preparation and physical properties of transparent conducting oxide films", Phys. Stat. Sol (a) Volume 71 pages 13 to 41 (year 1982). The drawback with these methods is that they generally require intentional heating of the substrate in order to foster the formation of TCO's on them.

Cathode grinding technology is renowned for its great versatility and the ease with which the process can be controlled as well as because it permits low temperature deposition. It has been steadily introduced on an industrial level in the last few years. This method is therefore an excellent candidate for the preparation of transparent electro-conducting oxides without substrate heating.

Consequently, an objective of the present invention is the preparation of tin-doped indium oxide and aluminium doped zinc oxide thin films on glass substrates, using the cathode grinding technique, in order to optimise their behaviour as transparent conducting oxides.

Cathode grinding is a process during which an atom or molecule is sputtered from a surface, called the "target surface" when the surface is bombarded by energy particles. After that, under certain conditions, this atom can be moved through space until it hits and condenses on a "substrate" surface. After repeating this process a number of times a thin film of material is eventually deposited on the substrate. This material is made up of the same material as that of the target surface. The processes for obtaining the films take place inside a vacuum chamber evacuated to a pressure of 10⁻⁶ mbar. The chamber has three gas nozzles: argon, oxygen and nitrogen. Argon (purity:99.999%) is used to reach a work pressure that will produce the discharge, whereas oxygen (purity: 99.999%) is added to provoke the TCO forming reaction as well as to stabilise the material during the absorption of oxygen in the air, and in this way, to limit the degradation of the electrical properties in time. Nitrogen (purity: industrial) is used to pressurise the chamber. There is a calibrated flux monitor at the entrance of the chamber both for argon and oxygen, which enables precise regulation of the flux. The flux varies between 0 and 150 sccm (standard cubic centimetres per minute) and between 0 and 10 for Ar and O₂, respectively.

Two targets surfaces with different compositions have been decided upon taking into account the types of possible applications: In₂O₃:SnO₂ (95/5% weight) and ZnO:AI₂O₃ (98/2% weight). Both targets, 75mm in diameter and 6mm thick, are joined to the two copper cathodes by means of a special glue (epoxide resin) which meets the necessary requirements in that it is a good thermal and electrical conductor and can also be used in vacuum processes. The cathodes are placed parallel to the substrates and are refrigerated by lines of water to avoid overheating of the grinding target surfaces from continuous ion bombardment and subsequent deterioration. There is a permanent magnet on their reverse side in order to increase the efficiency of the ionisation gas discharge and thus reduce the pressure needed to produce deposition. Both the target surfaces and the stations where the substrates are placed can be earthed or connected to a 13.56 MHz generator that provides radiofrequency power. When the stations are earthed and radiofrequency power is applied to the targets this results in deposition whereas if the connections are reversed this results in a cleansing of the substrates.

The process that is the claim of this patent improves the optical-electrical properties of TCO thin films made of ITO and Al:ZnO, prepared by means of cathode grinding on glass substrates without heating.

In order to complete the above description, and provide a better understanding of the invention characteristics, a detailed description will follow based on a set of drawings that accompany this specification. These are merely orientative and not exhaustive in their presentation of the following.

FIG. 1: is a graph that shows the evolution of squared resistance, R/ , with the position over the substrate, L, which corresponds to Al:ZnO samples prepared at different substrate temperatures.

FIG. 2: is a graph showing optical transmission spectrums according to wavelength, for ITO films prepared at different substrate temperatures.

FIG. 3: is a graph showing optical transmission spectrums according to wave length, for Al:ZnO films prepared at different substrate temperatures.

FIG. 4. is a graph that shows resistivity variation according to the oxygen flux inside the cathode grinding chamber during ITO film deposition without intentional heating of the substrate.

Glass substrates of areas up to 7 by 7cm² are employed for each preparation series. Given that substrate preparation and cleansing are essential for film adherence the substrates are degreased by means of various organic solvents and cleansed in ultrasonic baths with neutral water and soap. The first cleansing process is completed with intensive rinsing with deionised water and drying with a dry air gun. Later, once the substrates have been placed on their corresponding stations and the grinding chamber has been evacuated to an appropriate vacuum pressure, the substrates are bombarded with Ar⁺ ions to eliminate any remaining pollutants and improve film adherence.

In order to ensure reproduction of OCT films, all substances that may have adhered to the target surfaces whilst the chamber was open are eliminated by means of Ar⁺ ion bombardment.

Once these processes have been completed, grinding parameters are selected and grinding can commence

After considering all the possible preparation parameters that can modify transparency, conductivity and resistivity of ITO and Al:ZnO we have .found that the most critical deposition parameters are radiofrequency power density and O₂ flux. We have also observed that both must be controlled simultaneously.

The use of high power densities (4000 - 10000 mW/cm²) results in Ar⁺ ions having more energy to sputter atoms or molecules from target surfaces, and therefore the amount of material deposited on the glass substrates is greater. In this way high deposition speeds of up to 20 - 25 A/s are achieved, as well as greater ITO and Al:ZnO thicknesses, 5000 - 10000 A. Said increase in deposition speeds can lead to shorter process times and therefore to an improvement in industrial production costs. Thicknesses are analysed using profile metric measures that determine the even distribution of material on all the areas under consideration excepting substrate boundaries. This behaviour however, is a lot more evident in film depositions without substrate heating, because in such depositions the atoms and molecules that reach the substrate do not have enough energy to diffuse and move towards more extreme positions. There is generalised boundary heterogeneity at all temperatures used. This leads to crystal deterioration at the boundaries of the samples with a subsequent deterioration in the electrical quality of both TCO types in these areas. Electrical quality homogeneity can be increased by simply using larger size cathode grinding target surfaces, which means that the use of high powers is perfectly compatible with obtaining TCO's on large unheated substrates. A useful method for production on an industrial scale that entails significant energy saving is therefore a feasible alternative. Electrical quality, quantified by means of resistivity values, p, and squared resistance, R/ , has been determined using the conventional four point probes, P. Blood and J.W. Orton in "The electrical characterisation of semiconductors", Rep. Prog. Phys., Volume 41, pages 11 to 257 (year 1978).

The optical behaviour of films has been evaluated using spectrophotometric measures of light reflection and transmission through substrates with and without deposits.

Though the target surfaces are oxides and, in principle, the cathode grinding process should be non reactive, Ar⁺ ion bombardment against the target surfaces does not only sputter atoms and molecules from the surface but also modifies the oxidisation of the compound species reducing them to a metal state and thus substantially lowering transmission of the films. When the substrates are intentionally heated they provide sufficient energy of their own to promote the forming of oxides again and in this way they manage to recover high transparency. Y. Qu, T.A. Gessert, K. Ramanathan, R.G. Dhere, R. Noufi and T. J. Couts in "Electrical and optical properties of ion beam sputtered ZnO:AL films as a function of film thickness", J. Vac. Sci. Technol. A, Volume 11 pages 996 to 1000 (year 1993) and T. Nakada, N. Murakami and K. Kunioka in "Transparent conducting Al-, AlB₁₂ - and B-doped ZnO films for solar cells by dc magnetron sputtering", 12^{th} European Photovoltaic Solar Energy Conference, Amsterdam, Holland, pages 1507 to 1510 (year 1994).

However, in order to be able to eliminate heating systems and save on energy and material, in other words when there is no heating at all of substrates, it is necessary to use oxygen, in a very controlled way and in very small quantities, to oxidise the metal particles produced from bombardment and thus achieve greater than 85% transmission properties in the visible spectrum region.

It is only possible to achieve such high transmissions in the visible spectrum region and at the same time obtain resistivity levels of 10⁻³ -10⁻⁴ Ωcm if the flux of O₂ during the cathode grinding process is maintained within an extremely narrow range of 0.5 - 1 sccm. Mass flux speeds lower than 0.5 sccm produce samples with low transparency, because there is not enough O₂ in the chamber to react with the metallic atoms. As a result, the films take on a metallic appearance. On the other hand, if fluxes greater than lsccm are used, this leads to a deterioration in the conductive properties of the ITO and AL:ZnO because the oxygen fills up the vacancies in these materials and lowers the concentration of quasi-free electrons. An increase in O₂ also originates excessive oxidisation on the target surfaces that in turn lowers deposition speed and thickness. This leads to a reduction in ITO and AL:ZnO grain size and therefore of carrier mobility and conductivity. In addition, the injection of small quantities of O₂ produces a stabilisation of the material as regards the absorption of oxygen from the air and limits the degradation in time of its electrical characteristics without the need to use any stabilising gasses. The optical-electronical characteristics of a number of samples prepared without intentional heating of the substrate, that have been exposed to the air for five years, has shown that there has been no change in either the optical transmission values of the visible spectrum region or in electrical resistivity values.

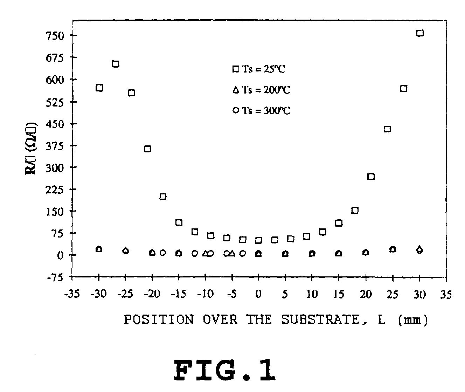

If we look at FIG. 1, this shows the electrical quality variation of aluminium-doped zinc oxide, quantified using squared resistance measurements, based on the L position on a 7x7cm² glass substrate. The L = O position indicates the location on the substrate of the geometrical centre of the cathode grinding target. The same figure also shows the evolution of the electrical property as well as the substrate temperature used during each deposition process. As previously stated during this invention description, the use of substrates without intentional heating produces heterogeneity in the border thickness of samples with a consequent deterioration in the electrical quality of the material. Though this behaviour has been observed at all the temperatures used, it is much more pronounced at very low temperatures, Ts=25°C. The total area with the appropriate electrical characteristics that are essential for the application of ITO and AL:ZnO is thus reduced. The same behaviour is also applicable to the ITO analysed in the present invention. However, electrical quality homogeneity can be increased by simply using larger size cathode grinding target surfaces.

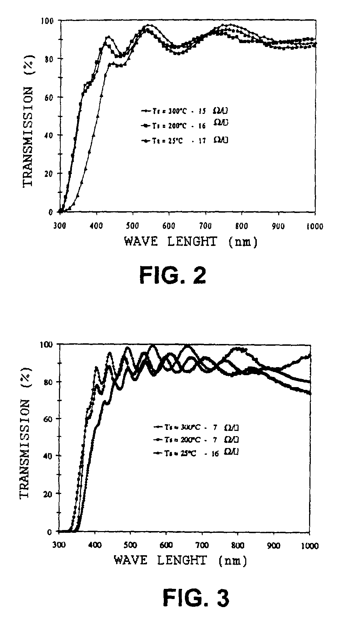

The optical properties of transparent conducting oxides, which are the object of this invention, are illustrated in FIG 2. and 3. They show us an example of how the use of different substrate temperatures during the cathode grinding process affects the wave length of the incidental radiation of optical transmission spectrums. They also indicate the electrical quality of samples obtained at each of the specified temperatures. FIG. 2 shows optical transmission of tin-doped indium oxide thin films whereas FIG. 3 shows optical transmission in aluminium-doped zinc oxide thin films. From these examples it becomes clear that it is possible to obtain acceptable optical electronical qualities for both types of materials not only at high temperatures but also when there is no heating of the substrate.

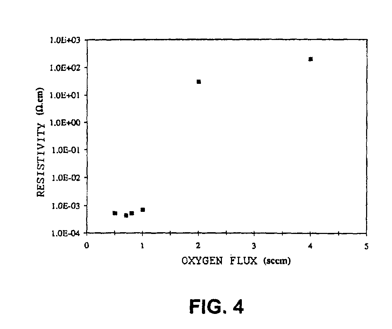

As stated previously, each technique with its associated parameters produces different properties. More specifically, in the case of ITO preparation without intentional heating of the substrate, FIG. 4, the flux of O2 injected into the chamber during the grinding process has a marked effect on the resistivity of deposited material. From this example we can see that the electrical quality of the TCO can be improved, in other words its resistivity can be lowered, by using very low fluxes of O2, which need to be strictly controlled and restricted within a narrow range.

From all the above it can be concluded that a process has been developed for forming compounds with high transparency in the visible spectrum region and with low resistivity, on substrates without intentional heating, and which can therefore be used in industry.

The quality achieved by the process followed in this invention should not be viewed as limited to a size of 7x7 cm² nor exclusively to glass substrates. The invention is ideally appropriate for the preparation of transparent conducting oxides without intentional heating of the substrate on large surfaces of different types of substrates.

## Claims

1. Method for obtaining electrical and transparent conducting oxides by means of cathode grinding without substrate heating, **characterised in that** it comprises the following stages:
- the preparation of the substrates by degreasing them with organic solvents and cleansing them in an ultrasonic bath with neutral water and soap, after which they are rinsed with deionised water and finally dried with an air pistol;
- the introduction of the substrates that are to be coated with transparent conducting oxides in a cathode grinding chamber, where they are bombarded with Ar⁺ ions;
- the preparation of indium oxide or zinc oxide target surfaces by bombarding them with Ar⁺ ions.
- the coating of the substrates with the materials which make up the targets, whilst a flux of argon and oxygen is maintained in the cathode grinding chamber.

2. Method for obtaining electrical and transparent conducting oxides by means of cathode grinding without substrate heating, according to claim 1, **characterised in that** the targets are made up of In2O3:SnO2 (95/5% in weight) and ZnO:Al2O3 (98/2% in weight), the argon flux is comprised between 0 and 150 sccm and the oxygen flux is comprised between 0.5 and 1 sccm and the radiofrequency power density between 4000 and 10000mW/cm2.
